(19) Europäisches Patentamt
European Patent Office
Office européen des brevets

(11) **EP 4 254 751 A1**

(12) **EUROPEAN PATENT APPLICATION**
published in accordance with Art. 153(4) EPC

(43) Date of publication:
**04.10.2023 Bulletin 2023/40**

(21) Application number: **20967547.9**

(22) Date of filing: **30.12.2020**

(51) International Patent Classification (IPC):
***H02M 1/00*** (2006.01)

(52) Cooperative Patent Classification (CPC):
Y02B 70/10

(86) International application number:
**PCT/CN2020/141431**

(87) International publication number:
**WO 2022/141206 (07.07.2022 Gazette 2022/27)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.
Shenzhen, Guangdong 518129 (CN)**

(72) Inventors:
• **PAN, Liwen
Shenzhen, Guangdong 518129 (CN)**

• **FENG, Hui
Shenzhen, Guangdong 518129 (CN)**
• **WANG, Deyuan
Shenzhen, Guangdong 518129 (CN)**
• **JIN, Xinyu
Shanghai 200240 (CN)**

(74) Representative: **Huawei European IPR
Huawei Technologies Duesseldorf GmbH
Riesstraße 25
80992 München (DE)**

(54) **DIGITAL SIGNAL MODULATION METHOD AND APPARATUS, SWITCHED-MODE POWER SUPPLY CONTROL METHOD, AND SWITCHED-MODE POWER SUPPLY**

(57) This application provides a digital signal modulation method, including: obtaining a modulation value of a comparator based on a target duty cycle and an initial value of a counter; obtaining a calibration value based on the target duty cycle, the initial value of the counter, and the modulation value of the comparator; generating periodic PWM signals based on the modulation value of the comparator and the initial value of the counter; and performing pulse frequency modulation on a PWM signal in each period of the periodic PWM signal based on the calibration value. In this application, pulse frequency modulation is performed on a PWM signal in each period without increasing hardware costs, to improve duty cycle precision of the PWM signal in each period, so as to output a PWM signal with higher precision.

S401
Obtain a modulation value of a comparator based on a target duty cycle and an initial value of a counter

S402
Obtain a calibration value based on the target duty cycle, the initial value of the counter, and the modulation value of the comparator

S403
Generate periodic PWM signals based on the modulation value of the comparator and the initial value of the counter

S404
Perform PFM on a PWM signal in each period in the periodic PWM signals based on the calibration value

FIG. 4

EP 4 254 751 A1

## Description

## TECHNICAL FIELD

This application relates to the field of digital coding technologies, and in particular, to a digital signal modulation method and apparatus, a power converter control method, and a power converter.

## BACKGROUND

With the increasing maturity of manufacturing techniques of silicon carbide (SiC) devices and gallium nitride (GaN) devices, more power converters are designed by using SiC power modules or GaN power modules. The SiC power module or the GaN power module has a relatively good frequency switching characteristic, and can implement a switching frequency of hundreds of KHz (kilohertz), where the switching frequency of the GaN power module may even be higher. A higher switching frequency can significantly reduce the size of the inductor-capacitor-transformer in the power converter, which is the key to improve the power density of the entire system.

The power converter is applicable for different application scenarios. In a low-power application scenario, an analog chip may be used to generate an analog PWM signal to control working of the power converter, and in a medium- and high-power application scenario, a programmable controller may be used to generate a digital PWM signal to control working of the power converter. Analog PWM signals are continuously changing signals, and once the analog PWM signals are calibrated, there is no precision problem. Digital PWM signals simulate continuously changing signals by using discrete values. A clock of a common digital PWM generator does not exceed 200 MHz. Therefore, when a switching frequency is relatively high, the discrete value is excessively high, which affects precision of the digital PWM signal.

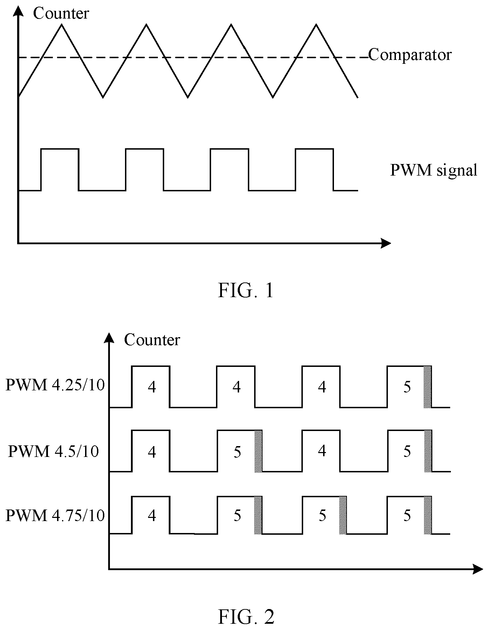

As shown in FIG. 1, a digital PWM generator generates a corresponding PWM signal by setting a value of a counter (Counter) and a value of a comparator (Comparator), and a duty cycle of the PWM signal may be obtained based on a ratio of the value of the comparator to the value of the counter. Modulation modes of the PWM signal can be classified into pulse width modulation (Pulse width modulation, PWM) and pulse frequency modulation (Pulse frequency modulation, PFM). In pulse width modulation, pulse width may be changed by modifying the value of the comparator, so as to change the duty cycle. In pulse frequency modulation, pulse frequency may be changed by modifying the value of the counter or modifying both the value of the counter and the value of the comparator, so as to change the duty cycle. However, pulse frequency modulation usually causes a pulse frequency jitter in a relatively wide range. A common power converter is unlikely to work in a very wide frequency range. Therefore, an actual adjustable duty cycle range of pulse frequency modulation is not large, and an application scope is relatively small, for example, pulse frequency modulation is generally used in an LLC resonant circuit.

When pulse width modulation is used to modulate a PWM signal, an existing microcontroller unit can configure PWM signal output to the dither mode, so that a value of the comparator jitters in a specific range, and precision of the average duty cycle is improved. As shown in FIG. 2, it is assumed that the value of the counter of the PWM signal is 10. After the value of the comparator is set to regularly jitter between 4 and 5 in four periods, PWM signals with an average duty cycle of 4.25/10, 4.5/10, and 4.75/10 may be implemented. Generally, a maximum of 4-bit jitter can be configured for a microcontroller unit. A disadvantage of the dither mode is that time is required for exchange of precision. Based on an exponential relationship between a jitter value and time, for example, if the jitter value is increased by 2 bits, it takes four periods to implement a duty cycle precision of 4.75/10; or if the jitter value is increased by 4 bits, it takes 16 periods to implement the duty cycle precision of 4.75/10. For a scenario that requires a higher precision, a 4-bit dither mode is adopted, which significantly reduces an output response speed. In addition, the dither mode further increases an output filtering difficulty, and a duty cycle of a PWM signal output in dither mode has a higher precision only than an average value, but the duty cycle precision of each cycle is still relatively low. The jitter of the duty cycle of the PWM signal may cause jitter of the output voltage and current, which may easily cause the switching frequency of a power converter to be lower than the frequency of ripple oscillations.

Based on the preceding disadvantage, a microcontroller unit with a higher frequency and performance may be selected. However, the frequency and performance of the microcontroller unit are only two to three times higher than those of a common microcontroller unit. The improvement is limited, but costs are increased significantly and the heat generated by the microcontroller unit is high.

## SUMMARY

In view of this, this application provides a digital signal modulation method and apparatus, a power converter control method, and a power converter. Pulse frequency modulation is performed on a PWM signal in each period without increasing hardware costs, so as to improve a duty cycle precision of the PWM signal in each period and output a PWM signal with a higher precision.

To achieve the foregoing objective, a first aspect of this application provides a digital signal modulation method, including:

obtaining a modulation value of a comparator based on a target duty cycle and an initial value of a counter;
obtaining a calibration value based on the target duty cycle, the initial value of the counter, and the modulation value of the comparator;

generating periodic PWM signals based on the modulation value of the comparator and the initial value of the counter; and

performing pulse frequency modulation on a PWM signal in each period in the periodic PWM signals based on the calibration value.

As described above, by using this method, a PWM technology is first used to generate periodic PWM signals based on a modulation value of a comparator and an initial value of a counter, then a PFM technology is used to perform pulse frequency modulation on a PWM signal in each period based on a calibration value, and a duty cycle precision of the PWM signal in each period is improved by using a method of properly changing a frequency, so that a PWM signal of higher precision is implemented without increasing hardware costs.

According to the first aspect, in a first possible implementation of the digital signal modulation method, the obtaining a modulation value of a comparator based on a target duty cycle and an initial value of a counter includes:

obtaining an accurate value of the comparator through calculation based on the target duty cycle and the initial value of the counter, and rounding the accurate value of the comparator to obtain the modulation value of the comparator.

As described above, the accurate value of the comparator may be obtained by performing a multiplication calculation based on the target duty cycle and the initial value of the counter. When the accurate value of the comparator has a decimal place, rounding is performed to obtain the modulation value of the comparator.

According to the first possible implementation of the first aspect, in a second possible implementation of the digital signal modulation method, the obtaining a calibration value based on the target duty cycle, the initial value of the counter, and the modulation value of the comparator includes:

when the duty cycle of the PWM signal is less than 0.5, obtaining a first precision value through calculation based on a difference between the modulation value of the comparator and the accurate value of the comparator, the modulation value of the comparator, and the initial value of the counter, and rounding the first precision value to obtain a first calibration value.

As described above, a corresponding calculation method is selected based on whether the duty cycle of the PWM signal is less than 0.5 to calculate a calibration value. When the duty cycle of the PWM signal is less than 0.5, the first precision value is obtained through calculation based on the difference between the modulation value of the comparator and the accurate value of the comparator, the modulation value of the comparator, and the initial value of the counter. When the first precision value has a decimal place, rounding is performed to obtain the first calibration value, and the initial value of the counter is modulated by using the first calibration value, so as to implement frequency modulation on the generated PWM signal in each period, thereby further improving a duty cycle precision of the PWM signal in each period.

According to the second possible implementation of the first aspect, in a third possible implementation of the digital signal modulation method, the performing pulse frequency modulation on a PWM signal in each period in the periodic PWM signals based on the calibration value includes:

modulating the initial value of the counter of the PWM signal in each period in the periodic PWM signals based on the first calibration value.

As described above, pulse frequency modulation includes high-level fixed-length pulse frequency modulation and low-level fixed-length pulse frequency modulation. The high-level fixed-length pulse frequency modulation means that a high-level pulse width remains unchanged and only the initial value of the counter is modulated. The low-level fixed-length pulse frequency modulation means that a low-level pulse width remains unchanged and the modulation value of the comparator and the initial value of the counter need to be modulated at the same time. In this method, when a duty cycle of a generated PWM signal is less than 0.5, the high-level fixed-length pulse frequency modulation may be selected to modulate the initial value of the counter, thereby improving the duty cycle precision of a finally output PWM signal.

According to the third possible implementation of the first aspect, in a fourth possible implementation of the digital signal modulation method,

when the accurate value of the comparator is rounded down, subtraction modulation is performed on the initial value of the counter of the PWM signal in each period in the periodic PWM signals based on the first calibration value; or
when the accurate value of the comparator is rounded up, addition modulation is performed on the initial value of the counter of the PWM signal in each period in the periodic PWM signals based on the first calibration value.

As described above, when the duty cycle of the generated PWM signal is less than 0.5, the high-level fixed-length pulse frequency modulation is selected, that is, the initial value of the counter needs to be modulated based on the first calibration value. In this case, a modulation direction is the same as a rounding direction. If the accurate value of the comparator is rounded down, that is, the modulation value of the comparator is less than the accurate value of the comparator, to further improve the duty cycle precision value, subtraction modulation also needs to be performed on the initial value of the counter, where a modulation amount is the first calibration value obtained by calculation. Similarly, if the accurate value of the comparator is rounded up, that is, the modulation value of the comparator is greater than the accurate value of the comparator, to further improve the duty cycle precision value, addition modulation also needs to be performed on the initial value of the counter.

According to the second possible implementation of the first aspect, in a fifth possible implementation of the digital signal modulation method, the method further includes:

when the duty cycle of the PWM signal is greater than or equal to 0.5, obtaining a second precision value through calculation based on the difference between the modulation value of the comparator and the accurate value of the comparator, a difference between the modulation value of the comparator and the initial value of the counter, and the initial value of the counter, and rounding the second precision value to obtain a second calibration value.

As described above, when the duty cycle of the PWM signal is greater than or equal to 0.5, the second precision value is obtained through calculation based on the difference between the modulation value of the comparator and the accurate value of the comparator, the difference between the modulation value of the comparator and the initial value of the counter, and the initial value of the counter. When the second precision value has a decimal place, rounding is performed to obtain the second calibration value. The initial value of the counter and the modulation value of the comparator are modulated by using the second calibration value, so as to implement frequency modulation on the generated PWM signal in each period, thereby further improving the duty cycle precision of the PWM signal in each period.

According to the fifth possible implementation of the first aspect, in a sixth possible implementation of the digital signal modulation method, the performing pulse frequency modulation on a PWM signal in each period in the periodic PWM signals based on the calibration value includes:

modulating the initial value of the counter and a modulation value of the comparator of the PWM signal in each period in the periodic PWM signals based on the second calibration value.

As described above, pulse frequency modulation includes high-level fixed-length pulse frequency modulation and low-level fixed-length pulse frequency modulation. The high-level fixed-length pulse frequency modulation means that a high-level pulse width remains unchanged and only the initial value of the counter is modulated. The low-level fixed-length pulse frequency modulation means that a low-level pulse width remains unchanged and the modulation value of the comparator and the initial value of the counter need to be modulated at the same time. In this method, when a duty cycle of a generated PWM signal is greater than or equal to 0.5, the low-level fixed-length pulse frequency modulation may be selected to modulate the modulation value of the comparator and the initial value of the counter, thereby improving the duty cycle precision of a finally output PWM signal.

According to the sixth possible implementation of the first aspect, in a seventh possible implementation of the digital signal modulation method,

when the accurate value of the comparator is rounded down, addition modulation is performed on the initial value of the counter and the modulation value of the comparator of the PWM signal in each period in the periodic PWM signals based on the second calibration value; or
when the accurate value of the comparator is rounded up, subtraction modulation is performed on the initial value of the counter and the modulation value of the comparator of the PWM signal in each period in the periodic PWM signals based on the second calibration value.

As described above, when the duty cycle of the generated PWM signal is greater than or equal to 0.5, low-level fixed-length pulse frequency modulation is selected, that is, the modulation value of the comparator and the initial value of the counter need to be modulated based on the second calibration value. In this case, the modulation direction is opposite to the rounding direction, that is, when the accurate value of the comparator is rounded down, addition modulation is performed on the initial value of the counter and the modulation value of the comparator; and conversely, when the accurate value of the comparator is rounded up, subtraction modulation is performed on the initial value of the counter and the modulation value of the comparator, thereby improving the duty cycle precision of the PWM signal in each period.

According to the fourth possible or seventh possible implementation of the first aspect, in an eighth possible implementation of the digital signal modulation method, the rounding includes:
performing the rounding by taking a closest integer value.

As described above, when the precision value of the comparator, the first precision value, and the second precision value are rounded, a round-off method may be used to obtain a closest integer value, so as to obtain a PWM signal closest to the target duty cycle through modulation.

To achieve the foregoing objective, a second aspect of this application provides a digital signal modulation apparatus, including:

a calculation unit, configured to obtain a modulation value of a comparator based on a target duty cycle and an initial value of a counter, and obtain a calibration value based on the target duty cycle, the initial value of the counter, and the modulation value of the comparator;
a pulse width modulation unit, configured to generate periodic PWM signals based on the modulation value of the comparator and the initial value of the counter;

and

a pulse frequency modulation unit, configured to perform pulse frequency modulation on a PWM signal in each period in the periodic PWM signals based on the calibration value.

According to the second aspect, in a first possible implementation of the digital signal modulation apparatus, the obtaining a modulation value of a comparator based on a target duty cycle and an initial value of a counter includes:

obtaining an accurate value of the comparator through calculation based on the target duty cycle and the initial value of the counter, and rounding the accurate value of the comparator to obtain the modulation value of the comparator.

According to the first possible implementation of the second aspect, in a second possible implementation of the digital signal modulation apparatus, the obtaining a calibration value based on the target duty cycle, the initial value of the counter, and the modulation value of the comparator includes:

when the duty cycle of the PWM signal is less than 0.5, obtaining a first precision value through calculation based on a difference between the modulation value of the comparator and the accurate value of the comparator, the modulation value of the comparator, and the initial value of the counter, and rounding the first precision value to obtain a first calibration value.

According to the second possible implementation of the second aspect, in a third possible implementation of the digital signal modulation apparatus, the performing pulse frequency modulation on a PWM signal in each period in the periodic PWM signals based on the calibration value includes:

modulating the initial value of the counter of the PWM signal in each period in the periodic PWM signals based on the first calibration value.

According to the third possible implementation of the second aspect, in a fourth possible implementation of the digital signal modulation apparatus,

when the accurate value of the comparator is rounded down, subtraction modulation is performed on the initial value of the counter of the PWM signal in each period in the periodic PWM signals based on the first calibration value; or
when the accurate value of the comparator is rounded up, addition modulation is performed on the initial value of the counter of the PWM signal in each period in the periodic PWM signals based on the first calibration value.

According to the second possible implementation of the second aspect, in a fifth possible implementation of the digital signal modulation apparatus, the method further includes:

when the duty cycle of the PWM signal is greater than or equal to 0.5, obtaining a second precision value through calculation based on the difference between the modulation value of the comparator and the accurate value of the comparator, a difference between the modulation value of the comparator and the initial value of the counter, and the initial value of the counter, and rounding the second precision value to obtain a second calibration value.

According to the fifth possible implementation of the second aspect, in a sixth possible implementation of the digital signal modulation apparatus, the performing pulse frequency modulation on a PWM signal in each period in the periodic PWM signals based on the calibration value includes:

modulating the initial value of the counter and a modulation value of the comparator of the PWM signal in each period in the periodic PWM signals based on the second calibration value.

According to the sixth possible implementation of the second aspect, in a seventh possible implementation of the digital signal modulation apparatus,

when the accurate value of the comparator is rounded down, addition modulation is performed on the initial value of the counter and the modulation value of the comparator of the PWM signal in each period in the periodic PWM signals based on the second calibration value; or
when the accurate value of the comparator is rounded up, subtraction modulation is performed on the initial value of the counter and the modulation value of the comparator of the PWM signal in each period in the periodic PWM signals based on the second calibration value.

According to the fourth possible or seventh possible implementation of the second aspect, in an eighth possible implementation of the digital signal modulation apparatus, the rounding includes:

performing the rounding by taking a closest integer value.

To achieve the foregoing objective, a third aspect of this application provides a power converter control method, including:

determining a target duty cycle based on a rated voltage and a target output voltage of the power converter; and
executing a digital signal modulation method in the digital signal modulation methods based on the target duty cycle, and controlling the power converter by using an output PWM signal.

To achieve the foregoing objective, a fourth aspect of this application provides a power converter, including:

a switch circuit, where a PWM signal of the switch circuit is provided by the apparatus based on any one of the digital signal modulation apparatuses.

To achieve the foregoing objective, a fifth aspect of this application provides a computing device, including:

a bus;

a communications interface connected to the bus;
at least one processor connected to the bus; and
at least one memory, where the memory is connected to the bus and stores program instructions, and when the program instructions are executed by the at least one processor, the at least one processor is enabled to perform the method based on any one of the digital signal modulation methods or the power converter control method.

To achieve the foregoing objective, a sixth aspect of this application provides a computer-readable storage medium, where the computer-readable storage medium stores program instructions. When the program instructions are executed by a computer, the computer is enabled to perform the method based on any one of the digital signal modulation methods or the power converter control method.

To achieve the foregoing objective, a seventh aspect of this application provides a computer program product, including program instructions. When the program instructions are executed by a computer, the computer is enabled to perform the method based on any one of the digital signal modulation methods or the power converter control method.

These aspects and other aspects of this application are more concise and more comprehensive in descriptions of the following (a plurality of) embodiments.

**BRIEF DESCRIPTION OF DRAWINGS**

The following further describes features of this application and a relationship between the features with reference to the accompanying drawings. The accompanying drawings are all examples, and some features are not shown in actual proportions. In addition, in some accompanying drawings, common features that are not mandatory for this application in the field of this application may be omitted. Alternatively, additional features that are not mandatory for this application are not shown. A combination of the features shown in the accompanying drawings is not intended to limit this application. In addition, in this specification, same reference numerals represent same content. The specific accompanying drawings are described as follows:

FIG. 1 is a schematic diagram of an existing manner for generating a digital PWM signal;
FIG. 2 is a schematic diagram of modulating a duty cycle by using a dither mode;
FIG. 3 is a schematic diagram of comparison of duty cycle dispersion between pulse width modulation and pulse frequency modulation;
FIG. 4 is a schematic diagram of a digital signal modulation method according to an embodiment of this application;
FIG. 5 is a schematic diagram of PWM/PFM hybrid modulation according to an embodiment of this application;
FIG. 6 is a schematic diagram of a PWM/PFM hybrid modulation method according to an embodiment of this application;
FIG. 7 is a circuit diagram of a high-frequency miniaturized DAB converter according to an embodiment of this application;
FIG. 8 is a schematic diagram of a power transmission feature in a DAB change period according to an embodiment of this application;
FIG. 9 is a schematic diagram depicting a structure of a digital signal modulation apparatus according to an embodiment of this application; and
FIG. 10 is a schematic diagram depicting a structure of a computing device according to an embodiment of this application.

**DESCRIPTION OF EMBODIMENTS**

To make the objectives, technical solutions, and advantages of embodiments of this application clearer, the following clearly and completely describes the technical solutions in embodiments of this application with reference to the accompanying drawings in embodiments of this application. It is clear that the described embodiments are merely some rather than all of embodiments of this application. Generally, components of embodiments of this application described and shown in the accompanying drawings herein may be arranged and designed in various configurations. Therefore, the following detailed descriptions of embodiments of this application provided in the accompanying drawings are not intended to limit the scope of the claimed application, but merely to represent selected embodiments of this application. All other embodiments obtained by a person skilled in the art based on embodiments of this application without creative efforts shall fall within the protection scope of this application.

In this specification and claims, the terms "first, second, third, and the like" or similar terms such as a module A, a module B, and a module C are merely used to distinguish between similar objects, and do not represent a specific order of the objects. It may be understood that specific orders or sequences may be exchanged if permitted, so that embodiments of this application described herein can be implemented in an order other than an order illustrated or described herein.

In the following descriptions, involved reference numerals such as S110 and S120 that indicate steps do not necessarily indicate that the steps are to be performed based on the order, and consecutive steps may be transposed if allowed, or may be performed simultaneously.

The term "include" used in this specification and claims should not be construed as being limited to the content listed below, and does not exclude other elements or steps. It should be construed as specifying existence of a mentioned feature, whole, step, or part, but does not preclude existence or addition of one or more other features, wholes, steps, or parts and their groups. Therefore, the expression "a device including an apparatus A and an apparatus B" should not be limited to a device including only the components A and B.

"One embodiment" or "an embodiment" mentioned in this specification indicates that a particular feature, structure or property that is described with reference to the embodiment is included in at least one embodiment of this application. Therefore, the terms "in one embodiment" or "in an embodiment" that appear in this specification do not necessarily indicate a same embodiment, but may indicate a same embodiment. Further, in one or more embodiments, the particular features, structures, or properties can be combined in any proper manner, as will be clear from this disclosure to a person of ordinary skill in the art.

Before the specific implementations of this application are further described in detail, technical terms in embodiments of this application are described. Unless otherwise defined, all technical and scientific terms used in this specification have same meanings as those usually understood by a person skilled in the art of this application. In case of any inconsistency, the meaning described in this specification or the meaning obtained based on the content recorded in this specification shall be used. In addition, the terms used in this specification are merely for the purpose of describing embodiments of this application, but are not intended to limit this application.

To accurately describe technical content in this application and accurately understand this application, the following explanations, descriptions, or definitions are first provided for terms used in this specification before specific implementations are described.

PWM: pulse width modulation.

PFM: pulse frequency modulation.

PWM duty cycle: indicates a ratio of high level in a pulse cycle.

PWM resolution: indicates a quantity of PWM duty cycle adjustable levels.

Duty cycle dispersion: indicates a variation of duty cycles of two adjacent periods during pulse width modulation or pulse frequency modulation. A smaller duty cycle dispersion indicates a higher duty cycle adjustment precision.

In the following, the duty cycle dispersions of pulse width modulation (PWM) and pulse frequency modulation (PFM) are compared and analyzed to compare the duty cycle adjustable precisions in the two modulation modes.

First, a value of a counter (Counter) is set to n, and a value of a comparator (Compare) is set to k. For ease of calculation, in this embodiment of this application and the following embodiments, polarity reversal is configured for a PWM signal output by a microcontroller unit. When the value of the counter is configured to be less than or equal to the value of the comparator, a high-level PWM signal is output. When the value of the counter is greater than the value of the comparator, a low-level PWM signal is output. Therefore, it may be learned that a duty cycle of the PWM signal is k/n.

In this case, in pulse width modulation, the duty cycle dispersion is:

$$\frac{k+1}{n} - \frac{k}{n} = \frac{1}{n}$$

Pulse frequency modulation includes two modulation modes: high-level fixed-length modulation and low-level fixed-length modulation.

In high-level fixed-length pulse frequency modulation, the duty cycle dispersion is:

$$\frac{k}{n-1} - \frac{k}{n} = \frac{k}{n(n-1)}$$

or

$$\frac{k}{n} - \frac{k}{n+1} = \frac{k}{n(n+1)}$$

In low-level fixed-length pulse frequency modulation, the duty cycle dispersion is:

$$\frac{k+1}{n+1} - \frac{k}{n} = \frac{n-k}{(n+1)n}$$

or

$$\frac{k}{n} - \frac{k-1}{n-1} = \frac{n-k}{(n-1)n}$$

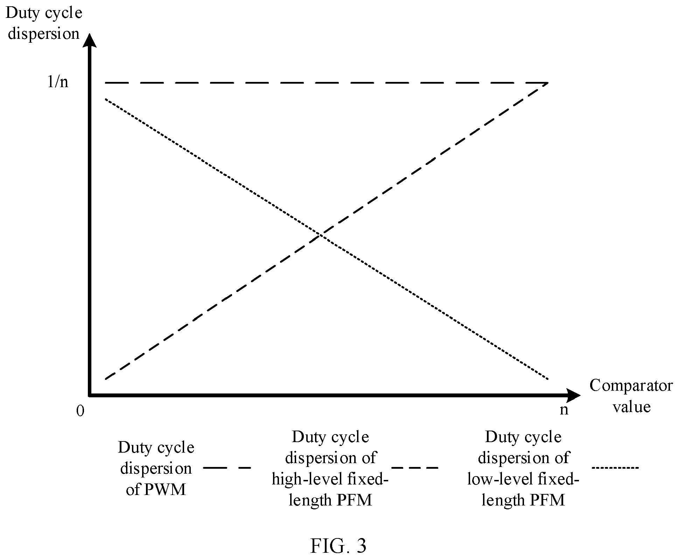

In this embodiment of this application, it is assumed that duty cycle dispersions in pulse width modulation and pulse frequency modulation are drawn. As shown in FIG. 3, by comparing the duty cycle dispersion in pulse width modulation and the duty cycle dispersion in pulse frequency modulation, it may be found that the duty cycle dispersion in pulse frequency modulation is always less than the duty cycle dispersion in pulse width modulation. In addition, based on FIG. 3, it can be further learned that when k < n/2, that is, when the duty cycle is less than 0.5, the duty cycle dispersion in the high-level fixed-length pulse frequency modulation is smaller. That is, when the duty cycle is less than 0.5, the high-level fixed-length pulse frequency modulation may be selected to implement modulation with a higher duty cycle precision. On the contrary, when k ≥ n/2, that is, when the duty cycle is greater than or equal to 0.5, the duty cycle dispersion in the low-level fixed-length pulse frequency modulation is smaller. That is, when the duty cycle is greater than or equal to 0.5, the low-level fixed-length pulse frequency modulation may be selected to implement modulation with a higher duty cycle precision.

However, if only the pulse frequency modulation is used for modulation, a pulse frequency jitters within a relatively wide range, making design of a magnetic element or a filter element of a circuit difficult to some extent.

On this basis, this embodiment of this application provides a digital signal modulation method. Through combination of advantages of the pulse width modulation and the pulse frequency modulation, the pulse width modulation is first used to generate periodic PWM signals, and then the pulse frequency modulation is performed on a PWM signal in each period. This method can avoid a problem that a pulse frequency of an output PWM signal changes significantly, and can further greatly improve a duty cycle precision of the output PWM signal. The following describes in detail this application.

**Embodiment 1**

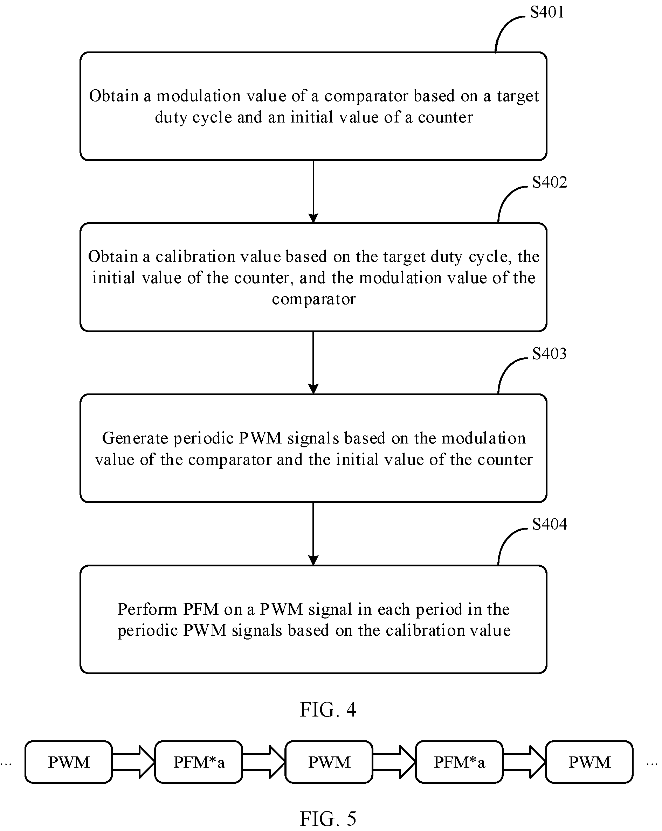

As shown in FIG. 4, in a digital signal modulation method provided in an embodiment of this application, the method includes the following steps.

S401: Obtain a modulation value of a comparator based on a target duty cycle and an initial value of a counter.

S402: Obtain a calibration value based on the target duty cycle, the initial value of the counter, and the modulation value of the comparator.

S403: Generate periodic PWM signals based on the modulation value of the comparator and an initial value of a counter.

S404: Perform pulse frequency modulation on a PWM signal in each period in the periodic PWM signals based on the calibration value.

In this method, the target duty cycle is a most precise duty cycle for achieving a working output target. For example, in a power converter, a target duty cycle required for accurately outputting the working voltage may be determined based on a working voltage and a rated voltage that need to be output by the power converter. The modulation value and the calibration value of the comparator that needs to reach the target duty cycle may be obtained through calculation based on the target duty cycle and the initial value of the counter of a digital PWM generator. The modulation value of the comparator refers to a value that needs to be set by the comparator, and the calibration value refers to a value required for addition modulation and subtraction modulation when pulse frequency modulation is performed on the PWM signal. In this application, based on a working principle of the digital PWM generator, the modulation value and the calibration value of the comparator are integer values that can be modulated on a premise that modulation precision is met. The calculation specifically includes:

A precise comparator value is obtained through calculation based on the target duty cycle and the initial value of the counter. For ease of description in the following, in this embodiment, the precise comparator value is defined as an accurate value of the comparator. If the accurate value of the comparator is a value with a decimal place, the accurate value of the comparator needs to be rounded to obtain a modulation value of the comparator for pulse width modulation.

For the rounded modulation value of the comparator, a specific deviation exists between the ratio of the rounded modulation value of the comparator to the initial value of the counter and the target duty cycle, where the deviation is less than a duty cycle dispersion generated by one pulse width modulation. In this case, further calculation may be performed based on the accurate value of the comparator, the modulation value of the comparator, and the initial value of the counter to obtain a calibration value for pulse frequency modulation. A process of calculating the calibration value needs to refer to a value of a duty cycle of a PWM signal, and the calculation process is performed based on a principle of obtaining a maximum calibration value. Specifically, when the duty cycle of the PWM signal is less than 0.5, that is, when the modulation value of the comparator is less than half of the initial value of the counter, the modulation value of the comparator is used as a denominator for calculation, and a first precision value is obtained through calculation based on a difference between the modulation value of the comparator and the accurate value of the comparator, the modulation value of the comparator, and the initial value of the counter. If the first precision value is a value with a decimal place, the first precision value needs to be rounded to obtain a first calibration value used for pulse frequency modulation. When the duty cycle of the PWM signal is greater than or equal to 0.5, that is, when the modulation value of the comparator is greater than or equal to half of the initial value of the counter, in this case, a difference between the initial value of the counter and the modulation value of the comparator is used as a denominator for calculation, and a second precision value is obtained through calculation based on the difference between the modulation value of the comparator and the accurate value of the comparator, the difference between the modulation value of the comparator and the initial value of the counter, and the initial value of the counter. If the second precision value is a value with a decimal place, the second precision value needs to be rounded to obtain a second calibration value used for pulse frequency modulation.

In the foregoing rounding process, the accurate value of the comparator, an integer value closest to the first precision value, and an integer value closest to the second precision value may be respectively obtained by using a round-off method, so as to implement more accurate pulse width modulation and pulse frequency modulation.

Pulse width modulation and pulse frequency modulation may be performed based on the modulation value of the comparator, the first calibration value, and second calibration value that are obtained through calculation. Specifically:

First, pulse width modulation is performed, and the digital PWM generator is set based on the modulation value of the comparator and the initial value of the counter, to generate periodic PWM signals. Based on the foregoing description, polarity reversal is configured for an output PWM signal in this embodiment of this application, and a duty cycle of a PWM signal in each period is a ratio of the modulation value of the comparator to the initial value of the counter.

The following describes a pulse frequency modulation process of the PWM signal in each period. It can be learned from FIG. 3 that, when k < n/2, that is, when the duty cycle is less than 0.5, a duty cycle dispersion in case of high-level fixed-length pulse frequency modulation is smaller. On the contrary, when k ≥ n/2, that is, when the duty cycle is greater than or equal to 0.5, a duty cycle dispersion in case of low-level fixed-length pulse frequency modulation is smaller. Therefore, based on the duty cycle of the PWM signal, the following pulse frequency modulation is performed on the PWM signal in each period in the periodic PWM signals:

when the duty cycle of the PWM signal is less than 0.5, performing addition modulation or subtraction modulation on the initial value of the counter of the PWM signal in each period based on the first calibration value, so that the duty cycle of the modulated PWM signal is closer to the target duty cycle; or
when the duty cycle of the PWM signal is greater than or equal to 0.5, performing addition modulation or subtraction modulation on the initial value of the counter and a modulation value of the comparator of the PWM signal in each period based on the second calibration value.

It is determined, based on whether the accurate value of the comparator is rounded down or rounded up, to perform subtraction modulation or addition modulation. Specifically:

When the accurate value of the comparator is rounded down, if the duty cycle of the PWM signal is less than 0.5, performing subtraction modulation for one or more times on the initial value of the counter of the PWM signal in each period based on the first calibration value, that is, subtracting the first calibration value from the initial value of the counter to obtain a final value of the counter, and if the duty cycle of the PWM signal is greater than or equal to 0.5, performing addition modulation for one or more times on the initial value of the counter and the modulation value of the comparator of the PWM signal in each period based on the second calibration value, that is, adding the second calibration value to the modulation value of the comparator and the initial value of the counter respectively, to obtain a final value of the comparator and a final value of the counter.

When the accurate value of the comparator is rounded up, if the duty cycle of the PWM signal is less than 0.5, performing addition modulation for one or more times on the initial value of the counter of the PWM signal in each period based on the first calibration value, that is, adding the first calibration value from the initial value of the counter to obtain a final value of the counter, and if the duty cycle of the PWM signal is greater than or equal to 0.5, performing subtraction modulation for one or more times on the initial value of the counter and the modulation value of the comparator of the PWM signal in each period based on the second calibration value, that is, subtracting the second calibration value to the modulation value of the comparator and the initial value of the counter respectively, to obtain a final value of the comparator and a final value of the counter.

In this embodiment of this application, the quantity of times of performing pulse frequency modulation is determined by a maximum precision of pulse frequency modulation. For example, when the maximum precision value of pulse frequency modulation is less than the first calibration value or the second calibration value, the first calibration value or the second calibration value cannot be reached after modulation is performed only once, and multiple times of modulation need to be performed.

As shown in FIG. 5, in this embodiment of this application, pulse frequency modulation is inserted into pulse width modulation. First, periodic PWM signals are generated by using pulse width modulation, and then pulse frequency modulation is further performed on a PWM signal in each period in the periodic PWM signals. After pulse frequency modulation on a single-period PWM signal is completed, a modulation value of a comparator and an initial value of a counter are restored, so that an initial duty cycle of a PWM signal in a next period is still a duty cycle of a PWM signal generated through pulse width modulation. Precision of the modulation method in this embodiment of this application is explained below by using the following formula. It is assumed that a duty cycle of a PWM signal generated by pulse width modulation is k/n, where k is a modulation value of a comparator, and n is an initial value of a counter. It is assumed that the first calibration value obtained through calculation is a and the second calibration value obtained through calculation is b. After pulse frequency modulation is performed, a difference between a duty cycle before modulation and a duty cycle after modulation is less than a duty cycle dispersion of pulse width modulation. The formula is as follows:

$$k < \frac{n}{2} \quad k \neq 0 \quad \frac{k}{n-a} - \frac{k}{n} = \frac{ak}{(n-a)n} < \frac{1}{n}$$

or

$$k < \frac{n}{2} \quad k \neq 0 \quad \frac{k}{n} - \frac{k}{n+b} = \frac{bk}{(n+b)n} < \frac{1}{n}$$

or

$$k \geq \frac{n}{2} \quad k \neq n \quad \frac{k+a}{n+a} - \frac{k}{n} = \frac{a(n-k)}{(n+a)n} < \frac{1}{n}$$

or

$$k \geq \frac{n}{2} \quad k \neq n \quad \frac{k}{n} - \frac{k-b}{n-b} = \frac{b(n-k)}{(n-b)n} < \frac{1}{n}$$

Therefore, it can be noted that in this embodiment of this application, compared with a case in which only pulse width modulation is performed, pulse frequency modulation is performed on a PWM signal in each period, so that duty cycle precision of the PWM signal in each period can be further improved, and duty cycle resolution of a single-period PWM signal is improved to a maximum extent without increasing hardware costs.

**Embodiment 2**

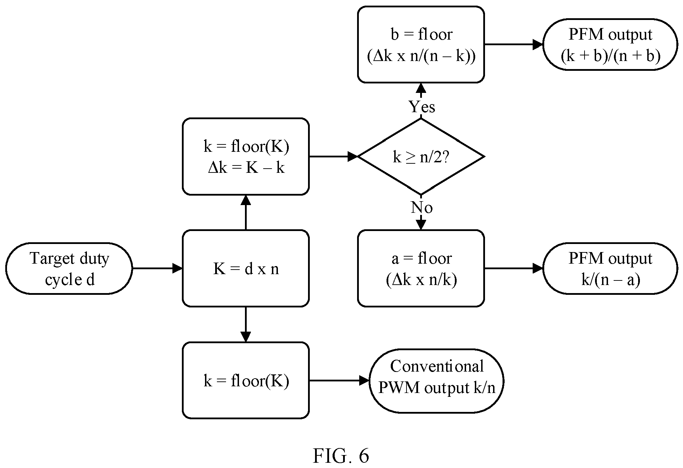

As shown in FIG. 6, in the PWM/PFM hybrid modulation method provided in this embodiment of this application, a required target duty cycle d is set by using a PI regulator (Proportional Integral Controller), and an accurate value K=d*n of a comparator corresponding to the target duty cycle may be obtained based on the target duty cycle d and an initial value n of a counter. The integer part k and the decimal part Δk may be obtained by rounding down the accurate value K of the comparator, and the floor function is a rounding down function:

$$k = floor(K);$$

and

$$\Delta k = K - k.$$

In conventional pulse width modulation, pulse width modulation may be implemented based on the integer part k obtained by rounding and the initial value n of the counter, and a PWM signal with a duty cycle of k/n is output. Precision of the duty cycle of the PWM signal output by the pulse width modulation is excessively low, and a difference between the duty cycle of the PWM signal and the target duty cycle set in the PI regulator is relatively large.

Therefore, in this embodiment of this application, a PWM/PFM hybrid modulation method is used. First, a PWM signal in each period is generated through modulation based on the integer part k and the initial value n of the counter through conventional pulse width modulation. A duty cycle of the PWM signal is k/n. Different from conventional pulse width modulation, in this embodiment of this application, further pulse frequency modulation needs to be performed on the PWM signal in each period.

According to whether the duty cycle of the PWM signal is greater than or equal to 0.5, that is, whether k is greater than or equal to n/2, different calibration value calculation manners and corresponding pulse frequency modulation are selected. Specifically:

When k<n/2, a high-level fixed-length PFM modulation mode is selected. In this case, the integer part k and the fractional part Δk are obtained by rounding, and the initial value n of the timer is calculated, and a calibration value a is calculated:

$$a = floor(\Delta k * n / k)$$

The calibration value a is used to perform high-level pulse frequency modulation with a fixed length, and modulate the PWM signal in each period, where a duty cycle output after the modulation is k/(n-a).

When k ≥ n/2, pulse frequency modulation with a low level unchanged is selected. In this case, the integer part k and the decimal part Δk are obtained by rounding, and the initial value n of the timer is calculated, and the calibration value b is calculated:

$$b = floor(\Delta k * n / n - k)$$

The calibration value b is used to perform high-level pulse frequency modulation with a fixed length, and modulate the PWM signal in each period. A duty cycle output after modulation is (k+b)/(n+b)λ.

The duty cycle k/(n -a) or (k+b)/(n+b) output after the pulse frequency modulation is more accurate than the duty cycle k/n of the PWM signal generated based on the rounded modulation value k of the comparator and the initial value n of the counter.

In some embodiments of this application, a rounding algorithm is not limited to a rounding-down function, and a rounding-off manner may be further used. Rounding up or rounding down may be performed based on an accurate value obtained through calculation, to obtain an integer value closest to the accurate value, so as to further improve precision of a duty cycle after modulation.

**Embodiment 3**

The following describes in detail a hybrid modulation method described in FIG. 6 with reference to a specific application scenario.

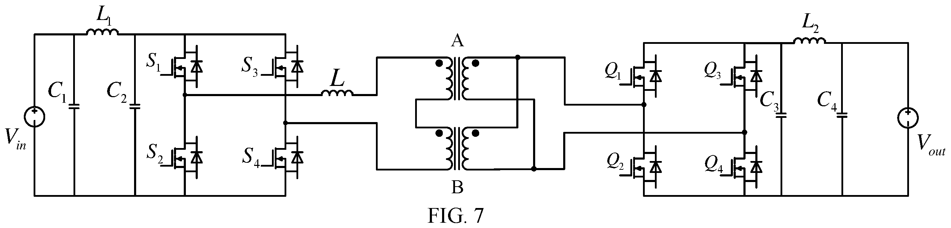

FIG. 7 is a circuit diagram of a high-frequency miniaturized DAB converter according to this embodiment of this application. The DAB (dual active full-bridge) converter is designed by using a silicon carbide (SiC) power module, and specifically includes: a primary filter circuit formed by an inductor L1 and capacitors C1 and C2, a primary full-bridge circuit of a high-frequency transformer formed by SiC power modules S1 to S4, a high-frequency inductor L, a high-frequency transformer circuit, a secondary full-bridge circuit of a high-frequency transformer formed by SiC power modules Q1 to Q4, and a secondary filter circuit formed by an inductor L2 and capacitors C3 and C4. The switching frequency of the DAB converter is set to 100 KHz.

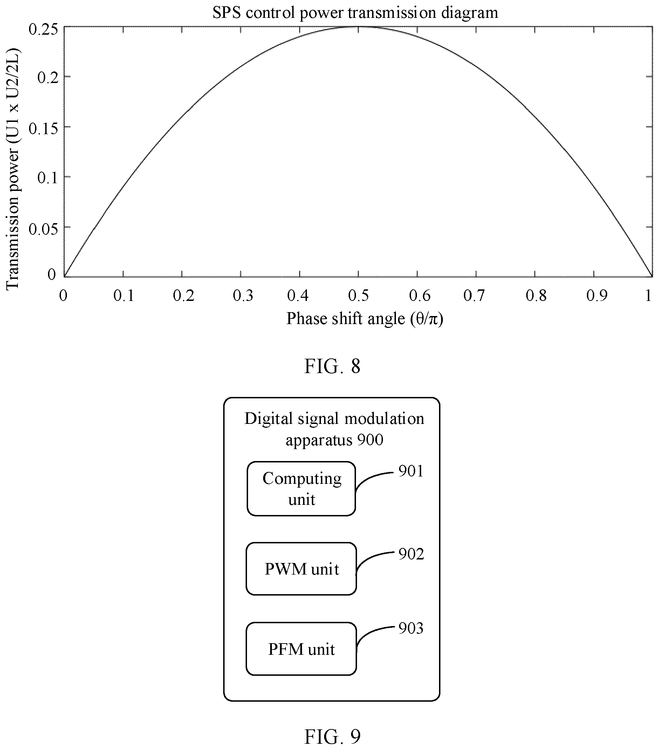

The DAB converter may use a single phase shift (Single phase shift, SPS) control mode. As shown in FIG. 8, in the SPS control mode, due to a special power transmission equation of the DAB converter, a phase shift angle of the DAB converter cannot exceed 90°. In addition, to reserve a margin of 30%, the phase shift angle of the DAB converter during rated operation is generally set to less than or equal to 45°.

In this embodiment of this application, a digital chip is used as a PWM generator to generate a PWM signal to control the DAB converter. The digital chip may be a chip in STM32G4 series. A clock frequency of the PWM signal generated by the digital chip is 170 MHz. Based on that the phase shift angle of the DAB converter working at a rated operating frequency does not exceed 45°, it may be obtained that when the DAB converter works at the rated operating frequency, a value of a period register (counter) of the digital chip is set to n = 170 MHz/100 KHz = 1700, and a value of a phase shift register (comparator) is set to k = 1700 x (45°/360°) ≈ 213. The value k of the phase shift register determines a value of a duty cycle k/n of the PWM signal generated by the digital chip, that is, the value k determines a power transmission magnitude of the DAB converter. To implement power transmission with a higher precision, the duty cycle k/n of the PWM signal needs to be modulated, so as to improve a duty cycle precision of the PWM signal.

In this embodiment of this application, a PWM/PFM hybrid modulation method is used to calculate a phase-shift duty cycle required by the DAB converter in each working state, determine the values of k and n that are closest to the phase-shift duty cycle, generate PWM signals through pulse width modulation, and then modulate a PWM signal in each period through pulse frequency modulation, so as to output a PWM signal with a higher phase-shift precision. Specifically:

When the DAB converter is in a rated working state with full load, based on a special power transmission equation of the DAB converter, the phase-shift angle output to the DAB converter is 45°, and correspondingly, the phase-shift duty cycle output to the DAB converter is d = 45°/360° = 0.125. According to this method, it can be learned that the accurate value of the comparator corresponding to the phase-shift duty cycle is K = 1700 x 0.125 = 212.5, and the accurate value of the comparator may be rounded down by using a rounding down function, so as to obtain:

$$k = \text{floor}(K) = 212;$$

and

$$\Delta k = K – k = 0.5.$$

Pulse width modulation is performed based on the modulation value k of the comparator and the value n of the phase shift register (comparator) that are obtained by rounding. The duty cycle of the generated PWM signal is 212/1700 ≈ 0.1247, the phase shift angle is 0.1247 x 360° = 44.892°, a deviation from the phase shift angle 45° is 0.11°, and a relative deviation percentage is 0.24%. Therefore, according to this method, pulse frequency modulation may be performed on the PWM signal in each period generated through the pulse width modulation.

Because the duty cycle d is less than 0.5, in this case, high-level fixed-length pulse frequency modulation is selected based on this application. Therefore, a calibration value a is calculated based on the integer part k and the fractional part Δk that are obtained by rounding and the value n of the phase shift register (comparator):

$$a = \text{floor}(\Delta k \text{ x } n/k) = \text{floor}(0.5 \text{ x } 1700/212) = 4$$

Because the accurate value of the comparator is rounded down, in this case, subtraction modulation is performed, based on the calibration value a, on PWM signals generated through pulse width modulation, to obtain a modulated phase-shift duty cycle:

$$k/n–a = 212/(1700-4) = 0.125$$

It can be learned that a deviation between the phase shift duty cycle after pulse frequency modulation and the phase shift duty cycle required for the DAB converter to be in the rated working state is 0, and a phase shift angle deviation is 0°. It can be learned that a duty cycle precision of a single-period PWM signal after pulse frequency modulation is obviously higher than the duty cycle precision before pulse frequency modulation. In this case, the switching frequency (a frequency of a PWM signal) of the DAB converter is 100 KHz x 1700/1696 ~ 100.24 KHz.

When the DAB converter is in a light-load working state, the phase-shift angle output to the DAB converter is 4.5°, and correspondingly, the phase-shift duty cycle output to the DAB converter is d = 4.5°/360° = 0.0125. According to this method, it can be learned that the accurate value of the comparator corresponding to the phase-shift duty cycle is K = 1700 x 0.0125 = 21.25, and the accurate value of the comparator may be rounded down by using a rounding down function, so as to obtain:

$$k = floor(K) = 21;$$

and

$$\Delta k = K-k = 0.25.$$

Pulse width modulation is performed based on the modulation value k of the comparator and the value n of the phase shift register (comparator) that are obtained by rounding. The duty cycle of the generated PWM signal is $21/1700 \approx 0.01235$, the phase shift angle is $0.01235 \times 360° = 4.446°$, a deviation from the phase shift angle 4.5° is 0.054°, and a relative deviation percentage is 1.11%. Therefore, according to this method, pulse frequency modulation may be performed on the PWM signal in each period generated through the pulse width modulation.

Because the duty cycle d is less than 0.5, in this case, high-level fixed-length pulse frequency modulation is selected based on this application. Therefore, a calibration value a is calculated based on the integer part k and the fractional part $\Delta k$ that are obtained by rounding and the value n of the phase shift register (comparator):

$$a = floor(\Delta k \times n/k) = floor(0.25 \times 1700/21) = 20$$

Because the accurate value of the comparator is rounded down, in this case, subtraction modulation is performed, based on the calibration value a, on PWM signals generated through pulse width modulation, to obtain a modulated phase-shift duty cycle:

$$k/n-a=21/(1700-20)=0.0125$$

It can be learned that a deviation between the phase shift duty cycle after pulse frequency modulation and the phase shift duty cycle required for the DAB converter to be in the rated working state is 0, and a phase shift angle deviation is 0°. In this case, the switching frequency (a frequency of a PWM signal) of the DAB converter is 100 KHz x 1700/1680 ~ 100.19 KHz.

In conclusion, in the PWM/PFM hybrid modulation method provided in this embodiment of this application, the duty cycle precision of the PWM signal output through modulation is obviously higher than the duty cycle precision of a conventional PWM signal output through pulse width modulation, and a relative deviation of the phase shift angle is smaller. In addition, a frequency fluctuation range of the PWM signal caused by pulse frequency modulation is relatively small, design difficulty of a filter circuit is not increased, and the working of the DAB converter is not significantly affected. In this application, without increasing any hardware cost, the duty cycle precision of a PWM signal in a single period can be improved, and the duty cycle resolution of the PWM signal can be greatly improved.

**Embodiment 4**

FIG. 9 is a schematic diagram depicting a structure of a digital signal modulation apparatus according to an embodiment of this application. The digital signal modulation apparatus 900 includes:

a calculation unit 901, configured to obtain a modulation value of a comparator based on a target duty cycle and an initial value of a counter, and obtain a calibration value based on the target duty cycle, the initial value of the counter, and the modulation value of the comparator;

a pulse width modulation unit 902, configured to generate periodic PWM signals based on the modulation value of the comparator and the initial value of the counter; and

a pulse frequency modulation unit 903, configured to perform pulse frequency modulation on a PWM signal in each period in the periodic PWM signals based on the calibration value.

In this embodiment of this application, the digital signal modulation apparatus 900 may be applied to any high-frequency power converter or power converter that is digitally controlled and uses a duty cycle or a phase shift angle to control output power, including but not limited to a buck/boost (boost and buck) circuit, a phase-shift full-bridge circuit, a forward circuit, a flyback circuit, an inverter circuit, and the like.

The target duty cycle used by the calculation unit 901 is a most precise duty cycle for achieving a working output target. For example, in a power converter, a target duty cycle required for accurately outputting the working voltage may be determined based on a working voltage and a rated voltage that need to be output by the power converter. The modulation value and the calibration value of the comparator that needs to reach the target duty cycle may be obtained through calculation based on the target duty cycle and the initial value of the counter of a digital PWM generator. The modulation value of the comparator refers to a value that needs to be set by the comparator, and the calibration value refers to a value required for performing addition modulation and subtraction modulation when pulse frequency modulation is performed on the PWM signal. In this application, based on a working principle of the digital PWM generator, the modulation value and the calibration value of the comparator need to be integers that can be reached on a premise that modulation precision is met. The calculation specifically includes:

A precise comparator value is obtained through calculation based on the target duty cycle and the initial value of the counter. For the convenience of differentiation in the following, in this embodiment, the precise comparator value is defined as an accurate value of the comparator. If the accurate value of the comparator is a value with a decimal place, the accurate value of the comparator needs to be rounded to obtain a modulation value of the comparator for pulse width modulation.

For the rounded modulation value of the comparator, a ratio of the modulation value of the comparator to the initial value of the counter still has a specific deviation from the target duty cycle. In this case, further calculation may be performed based on the accurate value of the comparator, the modulation value of the comparator, and the initial value of the counter, to obtain a calibration value for pulse frequency modulation. A process of calculating the calibration value needs to refer to a value of a duty cycle of a PWM signal, and the calculation process is performed based on a principle of obtaining a maximum calibration value. Specifically, when the duty cycle of the PWM signal is less than 0.5, that is, when the modulation value of the comparator is less than half of the initial value of the counter, the modulation value of the comparator is used as a denominator for calculation, and a first precision value is obtained through calculation based on a difference between the modulation value of the comparator and the accurate value of the comparator, the modulation value of the comparator, and the initial value of the counter. If the first precision value is a value with a decimal place, the first precision value needs to be rounded to obtain a first calibration value used for pulse frequency modulation. When the duty cycle of the PWM signal is greater than or equal to 0.5, that is, when the modulation value of the comparator is greater than or equal to half of the initial value of the counter, in this case, a difference between the initial value of the counter and the modulation value of the comparator is used as a denominator for calculation, and a second precision value is obtained through calculation based on the difference between the modulation value of the comparator and the accurate value of the comparator, the difference between the modulation value of the comparator and the initial value of the counter, and the initial value of the counter. If the second precision value is a value with a decimal place, the second precision value needs to be rounded to obtain a second calibration value used for pulse frequency modulation.

In the foregoing rounding process, the accurate value of the comparator, an integer value closest to the first precision value, and an integer value closest to the second precision value may be respectively obtained by using a round-off method, so as to implement more accurate pulse width modulation and pulse frequency modulation.

Pulse width modulation and pulse frequency modulation may be performed based on the modulation value of the comparator, the first calibration value, and second calibration value that are obtained through calculation. Specifically:

First, pulse width modulation is performed, and the digital PWM generator is set based on the modulation value of the comparator and the initial value of the counter, to generate periodic PWM signals. Based on the foregoing description, polarity reversal is configured for an output PWM signal in this embodiment of this application, and a duty cycle of a PWM signal in each period is a ratio of the modulation value of the comparator to the initial value of the counter.

The following describes a pulse frequency modulation process of the PWM signal in each period. It can be learned from FIG. 3 that, when $k < n/2$, that is, when the duty cycle is less than 0.5, a duty cycle dispersion in case of high-level fixed-length pulse frequency modulation is smaller. On the contrary, when $k \geq n/2$, that is, when the duty cycle is greater than or equal to 0.5, a duty cycle dispersion in case of low-level fixed-length pulse frequency modulation is smaller. Therefore, based on the duty cycle of the PWM signal, the following pulse frequency modulation is performed on the PWM signal in each period in the periodic PWM signals:

when the duty cycle of the PWM signal is less than 0.5, performing addition modulation or subtraction modulation on the initial value of the counter of the PWM signal in each period based on the first calibration value, so that the duty cycle of the modulated PWM signal is closer to the target duty cycle; and when the duty cycle of the PWM signal is greater than or equal to 0.5, performing addition modulation or subtraction modulation on the initial value of the counter and the modulation value of the comparator of the PWM signal in each period based on the second calibration value.

It is determined, based on whether the accurate value of the comparator is rounded down or rounded up, to perform subtraction modulation or addition modulation. Specifically:

When the accurate value of the comparator is rounded down, if the duty cycle of the PWM signal is less than 0.5, performing subtraction modulation on the initial value of the counter of the PWM signal in each period based on the first calibration value, that is, subtracting the first calibration value from the initial value of the counter to obtain a final value of the counter, and if the duty cycle of the PWM signal is greater than or equal to 0.5, performing addition modulation on the initial value of the counter and the modulation value of the comparator of the PWM signal in each period based on the second calibration value, that is, adding the second calibration value to the modulation value of the comparator and the initial value of the counter respectively, to obtain a final value of the comparator and a final value of the counter.

When the accurate value of the comparator is rounded up, if the duty cycle of the PWM signal is less than 0.5, performing addition modulation on the initial value of the counter of the PWM signal in each period based on the first calibration value, that is, adding the first calibration value to the initial value of the counter to obtain a final value of the counter; if the duty cycle of the PWM signal is greater than or equal to 0.5, performing subtraction modulation on the initial value of the counter and the modulation value of the comparator of the PWM signal in each period based on the second calibration value, that is, subtracting the second calibration value from the modulation value of the comparator and the initial value of the counter respectively, to obtain a final value of the comparator and a final value of the counter.

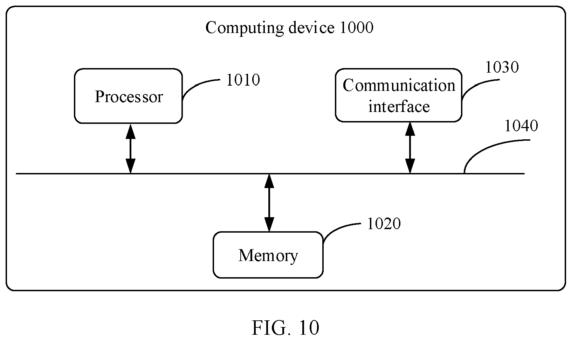

FIG. 10 is a schematic diagram of a structure of a computing device 1000 according to an embodiment of this application. The computing device 1000 includes a processor 1010, a memory 1020, a communications interface 1030, and a bus 1040.

It should be understood that the communications interface 1030 in the computing device 1000 shown in FIG. 10 may be used for communication with another device.

The processor 1010 may be connected to the memory 1020. The memory 1020 may be configured to store program code and data. Therefore, the memory 1020 may be an internal storage module of the processor 1010, may be an external storage module independent of the processor 1010, or may be a component that includes an internal storage module of the processor 1010 and an external storage module independent of the processor 1010.

The computing device 1000 may further include the bus 1040. The memory 1020 and the communications interface 1030 may be connected to the processor 1010 through the bus 1040. The bus 1040 may be a peripheral component interconnect (Peripheral Component Interconnect, PCI) bus, an extended industry standard architecture (Extended Industry Standard Architecture, EISA) bus, or the like. The bus 1040 may be classified into an address bus, a data bus, a control bus, or the like. For ease of indication, the bus is indicated by using only one line in FIG. 10. However, it does not indicate that there is only one bus or only one type of bus.

It should be understood that, in this embodiment of this application, the processor 1010 may be a central processing unit (central processing unit, CPU). The processor may be alternatively a general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or transistor logic device, or a discrete hardware component. The general-purpose processor may be a microprocessor, or the processor may be any conventional processor, or the like. Alternatively, the processor 1010 uses one or more integrated circuits, and is configured to execute a related program, to implement a technical solution provided in this embodiment of this application.

The memory 1020 may include a read-only memory and a random access memory, and provides instructions and data to the processor 1010. A part of the processor 1010 may further include a non-volatile random access memory. For example, the processor 1010 may further store device type information.

When the computing device 1000 runs, the processor 1010 executes computer-executable instructions in the memory 1020 to perform the steps of the foregoing method.

It should be understood that the computing device 1000 according to this embodiment of this application may correspond to a corresponding execution body of the method according to embodiments of this application, and the foregoing and other operations and/or functions of modules in the computing device 1000 are separately intended to implement corresponding procedures of the methods in embodiments. For brevity, details are not described herein again.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraints of the technical solutions. A skilled person may use different methods for particular applications to implement the described functions, but this implementation should not be considered as beyond the scope of this application.

It may be clearly understood by a person skilled in the art that, for convenience and brevity of description, for a specific working process of the foregoing system, apparatus, and unit, refer to a corresponding process in the method embodiment. Details are not described herein again.

In several embodiments provided in this application, it should be understood that the disclosed system, apparatus, and method may be implemented in other manners. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit.

When the function is implemented in a form of a software functional unit and sold or used as an independent product, the function may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, like a USB flash drive, a removable hard disk, a read-only memory (Read-Only Memory, ROM), a random access memory (Random Access Memory, RAM), a magnetic disk, or a compact disc.

An embodiment of this application further provides a computer-readable storage medium. The computer-readable storage medium stores a computer program, and when the program is executed by a processor, the program is used to perform a diversity problem generation method. The method includes at least one of the solutions described in the foregoing embodiments.

The computer storage medium in this embodiment of this application may be any combination of one or more read-only media. The read-only medium may be a read-only signal medium or a computer-readable storage medium. For example, the computer-readable storage medium may be, but is not limited to, an electric, magnetic, optical, electromagnetic, infrared, or semiconductor system, apparatus, or device, or any combination thereof. More specific examples (a non-exhaustive list) of the computer-readable storage medium include an electrical connection having one or more wires, a portable computer disk, a hard disk, a random access memory (RAM), a read-only memory (ROM), an erasable programmable read-only memory (EPROM or flash memory), an optical fiber, a portable compact disk read-only memory (CD-ROM), an optical storage device, a magnetic storage device, or any proper combination thereof. In this specification, the computer-readable storage medium may be any tangible medium that includes or stores a program, and the program may be used by or in combination with an instruction execution system, apparatus, or device.

The read-only signal medium may include a data signal propagated in a baseband or propagated as part of a carrier, where the data signal carries read-only program code. The propagated data signal may be in a plurality of forms, including but not limited to an electromagnetic signal, an optical signal, or any appropriate combination thereof. The read-only signal medium may alternatively be any read-only medium other than the computer-readable storage medium. The read-only medium may send, propagate, or transmit a program used by or in combination with an instruction execution system, apparatus, or device.

Program code included in the read-only medium may be transmitted by using any proper medium, including but not limited to wireless, an electric wire, an optical cable, RF, or any proper combination thereof.

Computer program code used to perform operations in this application may be written in one or more program design languages or a combination thereof. The program design language includes an object-oriented program design language like Java, Smalltalk, and C++, and further includes a conventional procedural program design language like a "C" language or a similar program design language. The program code may be executed entirely on a user computer, or some may be executed on a user computer as a separate software package, or some may be executed on a user computer while some is executed on a remote computer, or the code may be entirely executed on a remote computer or a server. When a remote computer is involved, the remote computer may be connected to a user computer by using any type of network, including a local area network (LAN) or a wide area network (WAN), or may be connected to an external computer (for example, connected by using an Internet service provider through the Internet).

It should be noted that the foregoing are merely example embodiments of this application and used technical principles. A person skilled in the art may understand that this application is not limited to specific embodiments described herein, and a person skilled in the art may make various obvious changes, readjustments, and replacements without departing from the protection scope of this application. Therefore, although this application is described in detail by using the foregoing embodiments, this application is not limited to the foregoing embodiments, and may further include more other equivalent embodiments without departing from the concept of this application. These embodiments all fall within the protection scope of this application.

**Claims**

1. A digital signal modulation method, comprising:

    obtaining a modulation value of a comparator based on a target duty cycle and an initial value of a counter;
    obtaining a calibration value based on the target duty cycle, the initial value of the counter, and the modulation value of the comparator;

generating periodic pulse width modulation PWM signals based on the modulation value of the comparator and the initial value of the counter; and

performing pulse frequency modulation on a PWM signal in each period in the periodic PWM signals based on the calibration value.

2. The method according to claim 1, wherein the obtaining a modulation value of a comparator based on a target duty cycle and an initial value of a counter comprises:

obtaining an accurate value of the comparator through calculation based on the target duty cycle and the initial value of the counter, and rounding the accurate value of the comparator to obtain the modulation value of the comparator.

3. The method according to claim 2, wherein the obtaining a calibration value based on the target duty cycle, the initial value of the counter, and the modulation value of the comparator comprises:

when a duty cycle of the PWM signal is less than 0.5, obtaining a first precision value through calculation based on a difference between the modulation value of the comparator and the accurate value of the comparator, the modulation value of the comparator, and the initial value of the counter, and rounding the first precision value to obtain a first calibration value.

4. The method according to claim 3, wherein the performing pulse frequency modulation on a PWM signal in each period in the periodic PWM signals based on the calibration value comprises:

modulating the initial value of the counter of the PWM signal in each period in the periodic PWM signals based on the first calibration value.

5. The method according to claim 4, wherein

when the accurate value of the comparator is rounded down, subtraction modulation is performed on the initial value of the counter of the PWM signal in each period in the periodic PWM signals based on the first calibration value; or when the accurate value of the comparator is rounded up, addition modulation is performed on the initial value of the counter of the PWM signal in each period based on the first calibration value.

6. The method according to claim 3, further comprising: when the duty cycle of the PWM signal is greater than or equal to 0.5, obtaining a second precision value through calculation based on the difference between the modulation value of the comparator and the accurate value of the comparator, a difference between the modulation value of the comparator and the initial value of the counter, and the initial value of the counter, and rounding the second precision value to obtain a second calibration value.

7. The method according to claim 6, wherein the performing pulse frequency modulation on a PWM signal in each period in the periodic PWM signals based on the calibration value comprises:

modulating the initial value of the counter and a modulation value of the comparator of the PWM signal in each period in the periodic PWM signals based on the second calibration value.

8. The method according to claim 7, wherein

when the accurate value of the comparator is rounded down, addition modulation is performed on the initial value of the counter and the modulation value of the comparator of the PWM signal in each period in the periodic PWM signals based on the second calibration value; or when the accurate value of the comparator is rounded up, subtraction modulation is performed on the initial value of the counter and the modulation value of the comparator of the PWM signal in each period in the periodic PWM signals based on the second calibration value.

9. The method according to claim 5 or 8, wherein the rounding comprises:
   performing the rounding by taking a closest integer value.

10. A digital signal modulation apparatus, comprising:

a calculation unit, configured to obtain a modulation value of a comparator based on a target duty cycle and an initial value of a counter, and obtain a calibration value based on the target duty cycle, the initial value of the counter, and the modulation value of the comparator;

a pulse width modulation unit, configured to generate periodic PWM signals based on the modulation value of the comparator and the initial value of the counter; and

a pulse frequency modulation unit, configured to perform pulse frequency modulation on a PWM signal in each period in the periodic PWM signals based on the calibration value.

11. The apparatus according to claim 10, wherein the obtaining a modulation value of a comparator based on a target duty cycle and an initial value of a counter comprises:
    obtaining an accurate value of the comparator through calculation based on the target duty cycle and the initial value of the counter, and rounding the accurate value of the comparator to obtain the modulation value of the comparator.

12. The apparatus according to claim 11, wherein the obtaining a calibration value based on the target duty cycle, the initial value of the counter, and the modulation value of the comparator comprises:
when a duty cycle of the PWM signal is less than 0.5, obtaining a first precision value through calculation based on a difference between the modulation value of the comparator and the accurate value of the comparator, the modulation value of the comparator, and the initial value of the counter, and rounding the first precision value to obtain a first calibration value.

13. The apparatus according to claim 12, wherein the performing pulse frequency modulation on a PWM signal in each period in the periodic PWM signals based on the calibration value comprises:
modulating the initial value of the counter of the PWM signal in each period in the periodic PWM signals based on the first calibration value.

14. The apparatus according to claim 13, wherein

when the accurate value of the comparator is rounded down, subtraction modulation is performed on the initial value of the counter of the PWM signal in each period in the periodic PWM signals based on the first calibration value; or
when the accurate value of the comparator is rounded up, addition modulation is performed on the initial value of the counter of the PWM signal in each period in the periodic PWM signals based on the first calibration value.

15. The apparatus according to claim 12, further comprising:
when the duty cycle of the PWM signal is greater than or equal to 0.5, obtaining a second precision value through calculation based on the difference between the modulation value of the comparator and the accurate value of the comparator, a difference between the modulation value of the comparator and the initial value of the counter, and the initial value of the counter, and rounding the second precision value to obtain a second calibration value.

16. The apparatus according to claim 15, wherein the performing pulse frequency modulation on a PWM signal in each period in the periodic PWM signals based on the calibration value comprises:
modulating the initial value of the counter and a modulation value of the comparator of the PWM signal in each period in the periodic PWM signals based on the second calibration value.

17. The apparatus according to claim 16, wherein

when the accurate value of the comparator is rounded down, addition modulation is performed on the initial value of the counter and the modulation value of the comparator of the PWM signal in each period in the periodic PWM signals based on the second calibration value; or
when the accurate value of the comparator is rounded up, subtraction modulation is performed on the initial value of the counter and the modulation value of the comparator of the PWM signal in each period in the periodic PWM signals based on the second calibration value.

18. The apparatus according to claim 14 or 17, wherein the rounding comprises:
performing the rounding by taking a closest integer value.

19. A power converter control method, comprising:

determining a target duty cycle based on a rated voltage and a target output voltage of a power converter; and
performing the digital signal modulation method according to any one of claims 1 to 9 based on the target duty cycle, to control the power converter by using an output PWM signal.

20. A power converter, comprising:
a switch circuit, wherein a PWM signal of the switch circuit is provided by the apparatus according to any one of claims 10 to 18.

21. A computing device, comprising:

a bus;
a communications interface connected to the bus;
at least one processor connected to the bus; and
at least one memory, wherein the memory is connected to the bus and stores program instructions, and when the program instructions are executed by the at least one processor, the at least one processor is enabled to perform the method according to any one of claims 1 to 9 or claim 19.

22. A computer-readable storage medium, wherein the computer-readable storage medium stores program instructions, and when the program instructions are executed by a computer, the computer is enabled to perform the method according to any one of claims 1 to 9 or claim 19.

**23.** A computer program product, comprising program instructions, wherein when the program instructions are executed by a computer, the computer is enabled to perform the method according to any one of claims 1 to 9 or claim 19.

Counter

Comparator

PWM signal

FIG. 1

Counter

PWM 4.25/10 | 4 | 4 | 4 | 5

PWM 4.5/10 | 4 | 5 | 4 | 5

PWM 4.75/10 | 4 | 5 | 5 | 5

FIG. 2

Duty cycle
dispersion

1/n

0                                                                                    n

Comparator
value

| Duty cycle dispersion of PWM | — — | Duty cycle dispersion of high-level fixed-length PFM | — — — | Duty cycle dispersion of low-level fixed-length PFM | ---------- |

FIG. 3

S401

Obtain a modulation value of a comparator based on a target duty cycle and an initial value of a counter

S402

Obtain a calibration value based on the target duty cycle, the initial value of the counter, and the modulation value of the comparator

S403

Generate periodic PWM signals based on the modulation value of the comparator and the initial value of the counter

S404

Perform PFM on a PWM signal in each period in the periodic PWM signals based on the calibration value

FIG. 4

··· PWM ⇒ PFM*a ⇒ PWM ⇒ PFM*a ⇒ PWM ···

FIG. 5

b = floor
(Δk x n/(n − k))

PFM output
(k + b)/(n + b)

Yes

k = floor(K)
Δk = K − k

k ≥ n/2?

No

Target duty
cycle d

K = d x n

a = floor
(Δk x n/k)

PFM output
k/(n − a)

k = floor(K)

Conventional
PWM output k/n

FIG. 6

FIG. 7

SPS control power transmission diagram

FIG. 8

Digital signal modulation
apparatus 900

Computing
unit — 901

PWM unit — 902

PFM unit — 903

FIG. 9

FIG. 10

# EP 4 254 751 A1

## INTERNATIONAL SEARCH REPORT

| International application No. |
|---|
| **PCT/CN2020/141431** |

| A. | CLASSIFICATION OF SUBJECT MATTER |
|---|---|
| | H02M 1/00(2007.01)i |

According to International Patent Classification (IPC) or to both national classification and IPC

| B. | FIELDS SEARCHED |
|---|---|

Minimum documentation searched (classification system followed by classification symbols)

H02M; H03K

Documentation searched other than minimum documentation to the extent that such documents are included in the fields searched

Electronic data base consulted during the international search (name of data base and, where practicable, search terms used)

CNABS, CNTXT, SIPOABS, DWPI, CNKI: 脉冲宽度调制, 占空比, 精度, 频率, 周期, 修正, 校正, 取整, PWM, pluse width modulation, duty factor, duty, accuracy, frequency, cycle, ajust+, round+

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 106688181 A (ROBERT BOSCH GMBH) 17 May 2017 (2017-05-17) description paragraphs [0022], [0031]-[0047], [0049], [0015] | 1-23 |
| A | CN 104767431 A (INTERNATIONAL GREEN CHIP CO., LTD.) 08 July 2015 (2015-07-08) entire document | 1-23 |
| A | CN 102739209 A (CHENGDU CHIP-RAIL MICROELECTRONIC CO., LTD.) 17 October 2012 (2012-10-17) entire document | 1-23 |
| A | US 6995592 B2 (ST MICROELECTRONICS PVT. LTD.) 07 February 2006 (2006-02-07) entire document | 1-23 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **22 September 2021** | **28 September 2021** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/141431**

| Patent document cited in search report | | | Publication date (day/month/year) | Patent family member(s) | | | Publication date (day/month/year) |
|---|---|---|---|---|---|---|---|
| CN | 106688181 | A | 17 May 2017 | CN | 106688181 | B | 17 January 2020 |
| | | | | US | 10158347 | B2 | 18 December 2018 |
| | | | | DE | 102014218010 | A1 | 10 March 2016 |
| | | | | US | 2017257081 | A1 | 07 September 2017 |
| | | | | WO | 2016037770 | A1 | 17 March 2016 |
| CN | 104767431 | A | 08 July 2015 | JP | 6301466 | B2 | 28 March 2018 |
| | | | | JP | 2017514429 | A | 01 June 2017 |
| | | | | WO | 2016155409 | A1 | 06 October 2016 |
| | | | | CN | 104767431 | B | 28 August 2018 |
| CN | 102739209 | A | 17 October 2012 | CN | 102739209 | B | 18 February 2015 |
| US | 6995592 | B2 | 07 February 2006 | US | 2005099217 | A1 | 12 May 2005 |

Form PCT/ISA/210 (patent family annex) (January 2015)